Europäisches Patentamt

European Patent Office

Office européen des brevets

(19)

(11) **EP 0 920 027 B1**

(12) **EUROPEAN PATENT SPECIFICATION**

(45) Date of publication and mention
of the grant of the patent:
**03.03.2004 Bulletin 2004/10**

(51) Int Cl.[7]: **G11C 11/412**

(21) Application number: **97120944.0**

(22) Date of filing: **28.11.1997**

(54) **A low power RAM memory cell with a single bit line**

RAM-Speicherzelle mit niedriger Leistungsaufnahme und einer einzigen Bitleitung

Cellule de mémoire RAM à consommation réduite avec une seule ligne de bit

(84) Designated Contracting States:
**DE FR GB IT**

(43) Date of publication of application:
**02.06.1999 Bulletin 1999/22**

(73) Proprietor: **STMicroelectronics S.r.l.**
**20041 Agrate Brianza (Milano) (IT)**

(72) Inventor: **Rimondi, Danilo**
**I-24030 Mozzo (Bergamo) (IT)**

(74) Representative: **Botti, Mario**
**Botti & Ferrari S.r.l.,**
**Via Locatelli, 5**
**20124 Milano (IT)**

(56) References cited:
**DE-A- 4 128 919**      **US-A- 5 276 652**
**US-A- 5 353 251**

• **PATENT ABSTRACTS OF JAPAN vol. 010, no. 180 (P-471), 24 June 1986 & JP 61 026997 A (TOSHIBA CORP), 6 February 1986,**

EP 0 920 027 B1

## Description

Background of the invention

The present invention relates to a low power RAM memory cell with a single bit line for a memory matrix comprising a plurality of word-lines and bit-lines, said cell including a first and a second cross-coupled CMOS inverters, each including a PMOS pull-up transistor and an NMOS pull-down transistor, and an access transistor connecting one of the inverter to the bit line.

The invention relates to integrated memory circuits and more specifically, but not exclusively, to integrated static random access memories.

As is well known, an electronic random access memory device includes a plurality of basic memory cells each comprising six transistors.

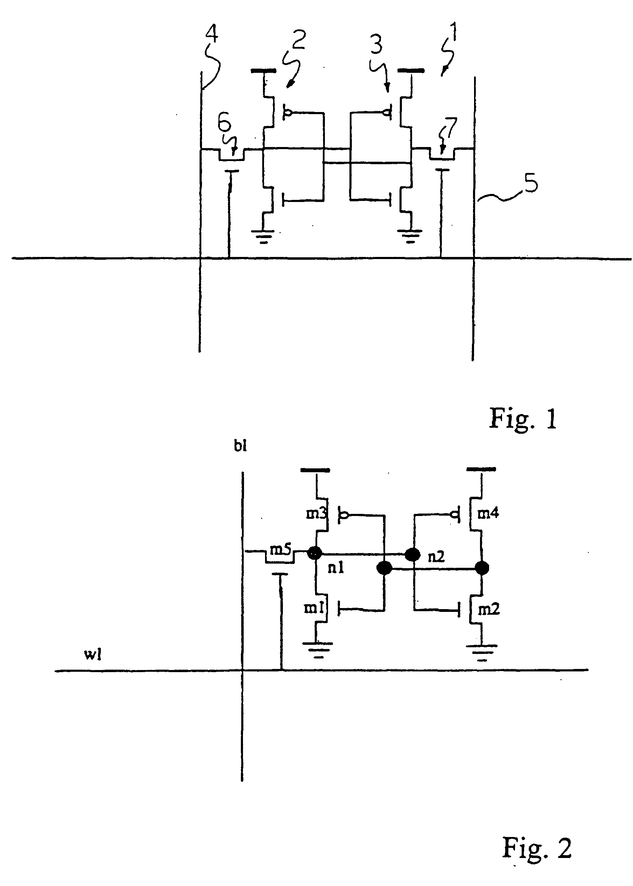

The enclosed figure 1 shows an example of a basic six transistors memory cell which is realised by CMOS technology. The cell 1 shown in figure 1 includes a pair of cross-coupled CMOS inverters 2 and 3 each of which is coupled to a corresponding bit line 4, 5 of the memory device. The first inverter 2 is coupled to the bit line 4 through a bi-directional access devices 6 while the second inverter 3 is coupled to the adjacent bit line 5 through a second bi-directional access devices 7.

During the reading and writing phases of the memory cell, a differential voltage must be applied between the bit lines 4, 5. In this respect, we might consider the cell access to the storage node as "differential".

In the reading phase, the bit line swing amplitude depends on how long the cells have been activated. The voltage difference due to the swing can be kept quite small and can be sensed by the sense amplifier of the memory device. This helps to reduce power consumption.

In the writing phase, the bit line voltage swing should be as large as possible, even a full CMOS level, in order to toggle the cells.

If we consider a RAM memory array or matrix having m rows and n columns, and including six transistors cells, the current consumption can be easily estimated using the following formulas:

$$Iddr = n * m * Cb * \Delta Vr \qquad (1)$$

for the reading phase, and

$$Iddw = n * m * Cb * \Delta Vw \qquad (2)$$

for the writing phase (assuming that the word written in the array consists of n bits);.
where: Cb is the bit line capacitance associated to a given cell; $\Delta Vr$ is the read voltage bit line swing and $\Delta Vw$ is the write voltage bit line swing. Usually $\Delta Vw$ corresponds to the supply voltage value Vdd.

Some prior art techniques are used to reduce the power dissipation of the memory matrix. Those techniques try to intervene on one or more of the parameters contained in the above formulas.

For instance, a first prior art solution is disclosed in: N. Kushiyama et al. "A 295 Mhz CMOS 1M (x256) embedded SRAM using I-directional read/write shared sense amplifiers and self-timed pulsed word-line drivers", ISSCC Dig. Tech. Papers Feb. 1995, pp. 182-183.

This solution proposes to reduce power dissipation by reducing the number of cells hung on the bit line using a hierarchical bit line scheme.

A second prior art solution is disclosed in: B. Amrutur and H. Horowitz "Technique to reduce power in fast wide memories" Dig. Tech. Papers, Oct. 1994, Symp. on Low Power Electronics, pp 92-93.

This second solution proposes to reduce power dissipation limiting the read bit line swing by controlling the word line pulse length.

A third prior art solution is disclosed in: T. Blalock and R. Jager " A high-speed clamped bit line current-mode sense amplifiers" IEEE J. Solid State Circuits, vol. 26, No. 4, pp. 542-548, April 1991.

Even this solution proposes to reduce power dissipation limiting the read bit line swing, but using current-mode sense amplifiers; thus reducing $\Delta Vr$.

A further known solution proposes to limit the write bit line swing to a predetermined value, namely Vdd-Vt, using a NMOS transistors precharge phase.

Some attempts have also been performed to reduce the current consumption by providing a single bit line per memory cell rather than a bit line pair. The smaller bit-line capacitance offered by single bit-line cells decrease the current consumption.

For instance: the article by M. Ukita et al., " A single-bit-line cross-point cell activation (SCPA) architecture for ultra-low-power SRAMs", IEEE J. Solid State Circuits, vol. 28, No, 11, pp. 1114-1118, November 1993, relates to a single bit line architecture including RAM cells with five transistors and a single bit line, as shown in Figure 2.

Another static random access memory including a plurality of memory cells with five transistors and a single bit line is described in the US Patent No. 5,276,652 to Anami.

Moreover, another article by K.J. O'Connor, "A source sensing technique applied to SRAM cells", IEEE J. Solid State Circuits, vol. 30, No, 4, pp. 500-511, April 1995, relates to the problem of writing a single access RAM cell.

As a matter of fact, during the reading phase of a single access memory cell, the probability of switching is dependent on the data stored in the cell. Hence, the power dissipation is statistically reduced by half.

During the writing phase, the bit lines are discharged only when a logic value "0" must be written. Hence, even in such a case, the probability of switching is statistically reduced by half.

However, single access memory cells present a serious drawback which comes from the difficulty of writing a logic value "1" into the cells.

The last mentioned known solutions try to solve the problem of writing the logic value "1" into a single access memory cell. However, the proposed solutions require special techniques which are complex and increase also the design complexity of the memory circuit.

One object of the present invention is that of providing a SRAM memory device having a reduced power consumption.

Another object of the present invention is that of achieving a reduction in the probability of a bit line switching by using a single bit line per memory cell.

A further object of the present invention is that of providing a very simple write operation technique.

A further object of the present invention is that of providing an SRAM memory cell having very long wordlenght but a reduced power dissipation.

Summary of the invention

The solution idea behind this invention is that of precharging the source terminal of the pull-down transistor forming one of the inverters pair inside the cell.

More specifically, the inventive idea is that of precharging the single bit line cell in a logic state which may be easily changed in the writing phase.

We might even define this kind of action on the cell as a "reset" operation. In the specific case of the five transistors cell of the present invention the precharging logic state is a logic "1" and the "reset" operation is performed by applying a pulse signal on the source terminal of the driver transistor M1.

According to this solution idea, the technical problem is solved by a RAM memory cell according to the claim 1.

The features and advantages of the RAM memory cell according to the invention will be appreciated by the following description of a preferred embodiment given by way of non-limiting example with reference to the annexed drawings.

Brief description of the drawings

Figure 1 shows a simplified schematic diagram of a conventional and known double bit-line CMOS SRAM memory cell;

Figure 2 shows a simplified schematic diagram of a conventional and known single bit-line CMOS SRAM memory cell;

Figure 3 shows a simplified schematic diagram of a CMOS RAM memory cell according to the present invention;

Figure 4 shows a schematic diagram of a memory array including a plurality of the memory cells of figure 2;

Figure 5 shows a schematic timing diagram of the electric signals inside the memory cell of figure 3 during a write operation.

Detailed description

With reference to the above figures, a static random access memory cell according to the present invention is globally indicated with 10. The cell 10 is realised by a CMOS process.

The SRAM cell according to the present invention is specifically designed for a random access electronic memory device having a single bit line BL.

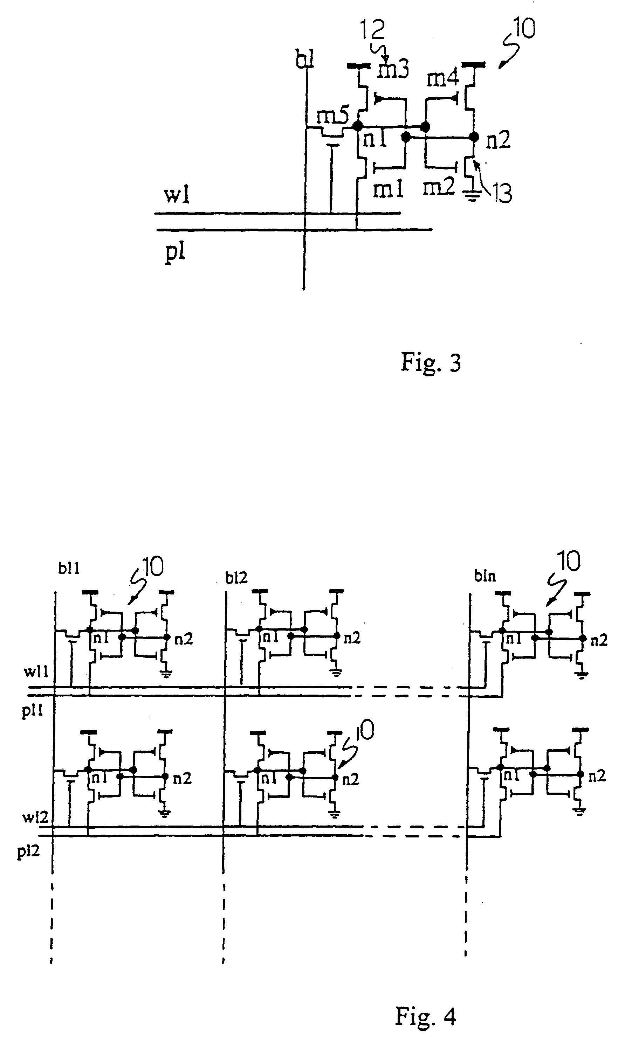

Each cell 10 is integrated in a memory array or matrix (partially shown in figure 4) including a plurality m of memory rows and a plurality n of memory columns.

The memory rows are identified as word lines WL of the memory device, while the memory columns are the bit lines BL of the memory device. Each cell 10 may be identified at the intersection between a word line WL and a single bit line BL.

The memory cell 10 comprises a couple of CMOS inverters 12 and 13 each including a pull-up PMOS transistor and a pull-down NMOS transistor. The two inverters 12, 13 are cross-coupled since the interconnection node between two transistors of one inverter is connected to the driving terminals of the other inverter.

The first inverter 12 comprises a PMOS transistor M3 and an NMOS transistor M1. The second inverter 13 comprises a PMOS transistor M4 and an NMOS transistor M2.

The transistors M1 and M3 of the first inverter 12 have their corresponding gate terminals connected to a first circuit internal node N1 which is connected to the drain common terminals of the other inverter 13.

The transistors M2 and M4 of the second inverter 13 have their corresponding gate terminals connected to a second circuit internal node N2 which is connected to the drain common terminals of the other inverter 12.

The source terminals of the PMOS transistors M3, M4 of the first and second inverters 12, 13 are both connected to a voltage supply line Vdd.

According to the present invention, the source terminal of the NMOS transistor M2 of the second inverter 13 is connected to a ground GND.

Moreover, the source terminal of the NMOS transistors M1 of the first inverter 12 is connected to a precharge line PL.

This precharge line PL is an extra line which is common to all the cells 10 of a memory row.

Therefore, according to the present invention the source of the driver transistor M1, instead of being grounded, is connected to the external precharge line PL.

The structure of the memory cell is completed by an access transistor M5 which connects the second circuit node N2 to the bit line.

This transistor M5, which may be a PMOS transistor, has the conduction terminals connected between the circuit node N2 and the corresponding bit line and the gate terminal connected to the word line WL.

Figure 4 shows a schematic diagram of the inside structure of the memory matrix including the plurality of cells 10 according to the present invention.

When the cell is not accessed, and during the reading phase, the precharge line PL is tied to ground. This provides a ground to the driver transistor M1. So, data retention and read operation is performed in the conventional manner.

Now, let's consider the usual problem for these kind of cells of over-writing a low logic value with a high logic value.

It the first node N1 in figure 2 is low and there is the need of writing a high logic value into the cell, than the bit line BL is set high and the word line WL is turned on.

This leads the transistors M5 and M1 to fight one: another. In order to make the cell stable during the read operation the prior art teaches to dimension the transistor M1 larger than the transistor M5. However, this makes writing quite difficult and requires special techniques as already mentioned when presenting the prior art problems.

According to the invention, the writing phase of the memory device is performed in three steps or phases which solve the prior art drawbacks:

1) the desired data is placed on the bit lines.: The bit lines are set high or low according to the memory word that must be written.

2) A pulse is applied to the precharge line PL. This pulse resets at the "1" logic value the internal node N1 of the cells 10 of an addressed word line.

The node which had been at a low logic value is now brought to the voltage level Vdd - Vtn by the NMOS driver transistor M1, and then brought at Vdd by the PMOS transistor M3.

The current path to ground is broken.

3) The word line WL is asserted, that is: only the cells having a grounded bit line will flip to the "0" logic value, the other cells will not change their logic state.

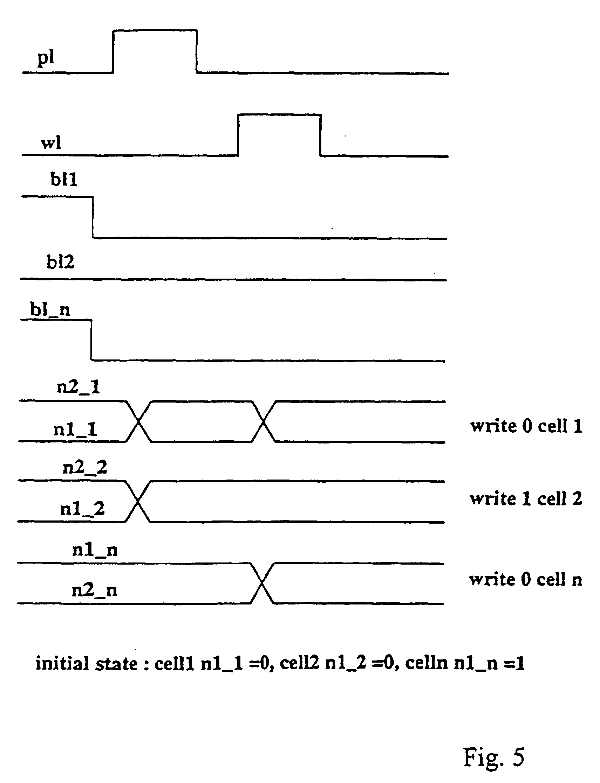

Figure 5 reports the timing diagrams of the whole write operation. These diagrams relate to the programming or write phase of a couple of memory cells and of the n-th cell of the memory word.

The skilled in the art may appreciate that the inventive principle may be applied even to a six transistors single bit line cell in which a sixth transistor M6 is connected between the node N2 and ground.

Such a sixth transistor would operate as a further access transistor to reset the node N1 to the logic value "1".

The gate terminal of this sixth transistor would be connected to the precharge line PL.

The advantage of this possible embodiment would be that of conferring to the cell a greater noise immunity since the "cell ratio" r is not altered by the presence of the sixth transistor.

The cell ratio is defined as: $r = (W1/L1)/(W6/L6)$

Where W1, W6 are the width of the transistors M1 and M6, while L1 and L6 are the lengths of these transistors.

The RAM memory cell according to the inventions has the great advantage of allowing a reduction of the power consumption. Moreover, this is obtained by a simple writing operation technique.

This advantage is specifically evident for memory structures having a very long wordlenght.

**Claims**

1.  A RAM memory cell (10) with a single bit line for a memory matrix comprising a plurality of word-lines (WL) and bit-lines (BL), said cell (10) including a first and a second cross-coupled CMOS inverters (12, 13), each including a PMOS pull-up transistor (M3, M4) and an MMOS pull-down transistor (M1, M2), and an access transistor (MS) connecting one of the inverter (13) to the bit line (BL), **characterised in that** the source terminal of a pull-down transistor (M1) is connected to a precharge line (PL) which is common to all the cells (10) of a memory row of said matrix memory.

2.  A RAM memory cell according to claim 1, **characterised in that** the gate terminal of the access transistor (M5) is connected to the word line (WL).

3.  A RAM memory cell according to claim 1, **characterised in that** the source terminal of a further pull-down transistor (M2) is connected to ground (GND).

4.  A RAM memory cell according to claim 1, **characterised in that** it further comprises an additional transistor (M6) connected between another one of the inverters (14) and ground (GND) and having a gate terminal connetted to said precharge line (PL).

5.  A RAM memory cell according to claim 1, **characterised in that** the current flow in said pull-down transistor (M1) is turned off during the writing phase of the memory cell.

**6.** A RAM memory cell according to claim 1, wherein the cell is a static RAM.

**7.** A method of writing a RAM memory cell (10) with a single bit line in a memory matrix comprising a plurality of word-lines (WL) and bit-lines (BL), said cell (10) including a first and a second cross-coupled CMOS inverters (12, 13), each including a PMOS pull-up transistor (M3, M4) and an NMOS pull-down transistor (M1, M2), and an access transistor (M5) connecting one of the inverter (13) to the bit line (BL), **characterised in** precharging the single bit line cell in a logic state which may be easily changed in the writing phase by a precharge line (PL) which is common to all the cells (10) of a memory row of said matrix memory.

**Patentansprüche**

**1.** Eine RAM-Speicherzelle (10) mit einer einzigen Bitleitung für eine Speichermatrix, die eine Vielzahl von Wortleitungen (WL) und Bitleitungen (BL) aufweist, wobei die Zelle (10) einen ersten und einen zweiten über Kreuz verschalteten CMOS-Inverter (12, 13), von denen jeder einen PMOS Pull-Up-Transistor (M3, M4) und einen NMOS Pull-Down-Transistor (M1, M2) aufweist, und einen Zugriffstransistor (M5) umfasst, der einen der Inverter (13) mit der Bitleitung (BL) verbindet, **dadurch gekennzeichnet, dass** der Source-Anschluss eines Pull-Down-Transistors (M1) mit einer Vorladungsleitung (PL) verbunden ist, die für all die Zellen (10) einer Speicherzeile des Matrixspeichers gemeinsam ist.

**2.** Eine RAM-Speicherzelle entsprechend Anspruch 1, **dadurch gekennzeichnet, dass** der Gate-Anschluss des Zugriffstransistors (M5) mit der Wortleitung (WL) verbunden ist.

**3.** Eine RAM-Speicherzelle entsprechend Anspruch 1, **dadurch gekennzeichnet, dass** der Source-Anschluss eines weiteren Pull-Down-Transistors (M2) mit Masse (GND) verbunden ist.

**4.** Eine RAM-Speicherzelle entsprechend Anspruch 1, **dadurch gekennzeichnet, dass** sie des weiteren einen zusätzlichen Transistor (M6) umfasst, der zwischen einen weiteren Inverter (14) und Masse (GND) geschaltet ist und einen mit der Vorladungsleitung (PL) verbundenen Gate-Anschluss aufweist.

**5.** Eine RAM-Speicherzelle entsprechend Anspruch 1, **dadurch gekennzeichnet, dass** der Stromfluss in dem Pull-Down-Transistor (M1) während der Schreibphase der Speicherzelle ausgeschaltet ist.

**6.** Eine RAM-Speicherzelle entsprechend Anspruch 1, wobei die Zelle ein statisches RAM ist.

**7.** Ein Verfahren zum Beschreiben einer RAM-Speicherzelle (10) mit einer einzigen Bitleitung in einer Speichermatrix, die eine Vielzahl von Wortleitungen (WL) und Bitleitungen (BL) aufweist, wobei die Zelle (10) einen ersten und einen zweiten über Kreuz verschalteten CMOS-Inverter (12, 13), von denen jeder einen PMOS Pull-Up-Transistor (M3, M4) und einen NMOS Pull-Down-Transistor (M1, M2) aufweist, und einen Zugriffstransistor (M5) umfasst, der einen der Inverter (13) mit der Bitleitung (BL) verbindet, **gekennzeichnet durch** Vorladen der einzigen Bitleitungs-Zelle auf einen Logikzustand, der in der Schreibphase auf einfache Weise über eine Vorladungsleitung (PL) verändert werden kann, die für all die Zellen (10) einer Speicherzeile des Matrixspeichers gemeinsam ist.

**Revendications**

**1.** Cellule de mémoire vive (10) avec une seule ligne de bits pour une matrice de mémoire, comprenant une pluralité de lignes de mots (WL) et de lignes de bits (BL), ladite cellule (10) incluant des premier et deuxième inverseurs CMOS à couplage transversal (12, 13), chacun incluant un transistor à excursion haute PMOS (M3, M4) et un transistor à excursion basse NMOS (M1, M2), et un transistor d'accès (M5) connectant l'un des inverseurs (13) à la ligne de bits (BL), **caractérisée en ce que** la borne source d'un transistor à excursion basse (M1) est connectée à une ligne de préchargement (PL) qui est commune à toutes les cellules (10) d'une rangée de mémoire de ladite mémoire matricielle.

**2.** Cellule de mémoire vive selon la revendication 1, **caractérisée en ce que** la borne de gâchette du transistor d'accès (M5) est connectée à la ligne de mots (WL).

**3.** Cellule de mémoire vive selon la revendication 1, **caractérisée en ce que** la borne source d'un autre transistor à excursion basse (M2) est connectée à la masse (GND).

**4.** Cellule de mémoire vive selon la revendication 1, **caractérisée en ce qu'**elle comprend en outre un transistor supplémentaire (M6) connecté entre l'autre des inverseurs (14) et la masse (GND) et ayant une borne de gâchette connectée à ladite ligne de préchargement (PL).

**5.** Cellule de mémoire vive selon la revendication 1, **caractérisée en ce que** le flux de courant dans ledit transistor à excursion basse (M1) est désactivé pendant la phase d'écriture de la cellule de mémoire.

6. Cellule de mémoire vive selon la revendication 1, dans laquelle la cellule est une mémoire statique.

7. Procédé d'écriture d'une cellule de mémoire vive (10) avec une seule ligne de bits dans une matrice de mémoire, comprenant une pluralité de lignes de mots (WL) et de lignes de bits (BL), ladite cellule (10) incluant des premier et deuxième inverseurs CMOS à couplage transversal (12, 13), chacun incluant un transistor à excursion haute PMOS (M3, M4) et un transistor à excursion basse NMOS (M1, M2), et un transistor d'accès (M5) connectant l'un des inverseurs (13) à la ligne de bits (BL), **caractérisée en ce qu'**on précharge la seule cellule de ligne de bits dans un état logique qui peut facilement être modifié dans la phase d'écriture par une ligne de préchargement (PL) qui est commune à toutes les cellules (10) d'une rangée de mémoire de ladite mémoire matricielle.

Fig. 1

Fig. 2

Fig. 3

Fig. 4

EP 0 920 027 B1

Fig. 5

9